# EUROPÄISCHE PATENTANMELDUNG

(11) **EP 0 902 461 A2**
(43) Veröffentlichungstag der Anmeldung: **17.03.1999**
(21) Anmeldenummer: 98114572.5
(22) Anmeldetag: 31.07.1998
(51) Int. Cl.: H01L 21/311

(54) **Verfahren zur Erzeugung von Strukturen mit einem hohen Aspektverhältnis**

(30) Priorität: 08.09.1997 DE 19739224
(71) Anmelder: SIEMENS AKTIENGESELLSCHAFT, 80333 München (DE)
(72) Erfinder: Weinrich, Volker, Dr., 81373 München (DE); Engelhardt, Manfred, Dr., 83620 Feldkirchen-Westerham (DE)

(57) **Zusammenfassung**

Erfindungsgemäß wird ein zur Erzeugung von Strukturen mit einem hohen Aspektverhältnis bereitgestellt, das die folgenden Schritte aufweist: das Material der zu erzeugenden Struktur wird in Form einer Schicht bereitgestellt, auf die Schicht wird eine Maske aufgebracht, die Schicht wird unter Verwendung der Maske trockengeätzt, so daß Redepositionen des Schichtmaterials an den Seitenwänden der Maske gebildet werden, die Maske wird entfernt, so daß eine Struktur mit einem hohen Aspektverhältnis zurückbleibt.

Durch das erfindungsgemäße Verfahren lassen sich sehr hohe (≥ 1 µm) und sehr dünne (≤ 50 nm) Strukturen in nur sehr wenigen Prozeßschritten und mit nur einer Maskentechnik relativ einfach und schnell erzeugen. Strukturen mit so großen Aspektverhältnissen, insbesondere wenn sie aus einem leitenden Material bestehen, können anders nicht oder nur mit hohem Aufwand erzeugt werden.

## Beschreibung

Die vorliegende Erfindung betrifft ein Verfahren zur Erzeugung von Strukturen mit einem hohen Aspektverhältnis sowie Strukturen mit einem hohen Aspektverhältnis.

Während der letzten 25 Jahre hat sich die Speicherdichte von DRAM-Speicherbausteinen von einer Generation zur nächsten Generation jeweils vervierfacht. Das prinzipielle Design einer elementaren Speicherzelle sowie die zum Aufbau der Speicherzelle verwendeten Materialien haben sich dabei jedoch im wesentlichen nicht verändert. Eine DRAM-Speicherzelle besteht wie vor 25 Jahren aus einem Transistor und einem Kondensator, der die zur Darstellung der Information notwendige Ladung speichert. Der Kondensator der Speicherzelle besitzt dabei Elektroden aus dotiertem Silizium bzw. Polysilizium und eine zwischen den Elektroden angeordnete dielektrische Schicht aus Siliziumdioxid und/oder Siliziumnitrid.

Um die in einem Kondensator gespeicherte Ladung reproduzierbar auslesen zu können, sollte die Kapazität des Kondensators mindestens einen Wert von etwa 30 fF besitzen. Gleichzeitig mußte und muß die laterale Ausdehnung des Kondensators ständig verkleinert werden, um die genannte Erhöhung der Speicherdichte erzielen zu können. Diese an sich gegenläufigen Anforderungen an den Kondensator der Speicherzelle führten und führen zu einer immer komplexeren Strukturierung des Kondensators ( 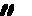 Trench-Kondensatoren", 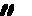 Stack-Kondensatoren", 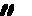 Kronen-Kondensatoren"), um trotz kleiner werdender lateraler Ausdehnung des Kondensators eine ausreichende Kondensatorfläche bereitstellen zu können. Dementsprechend wird jedoch die Herstellung des Kondensators immer aufwendiger und damit immer teurer.

Ein weiterer Weg, eine ausreichende Kapazität des Kondensators zu gewährleisten, liegt in der Verwendung anderer Materialien zwischen den Kondensatorelektroden. In letzter Zeit werden daher anstatt des herkömmlichen Siliziumoxids/ Siliziumnitrids neue Materialien, insbesondere Paraelektrika und Ferroelektrika, zwischen den Kondensatorelektroden einer Speicherzelle verwendet. Diese neuen Materialien besitzen eine deutlich höhere relative Dielektrizitätskonstante (> 20) als das herkömmliche Siliziumoxid/Siliziumnitrid (< 8). Daher kann durch den Einsatz dieser Materialien, bei gleicher Kapazität und gleicher lateralen Ausdehnung der Speicherzelle, die benötigte Kondensatorfläche und damit die benötigte Komplexität der Strukturierung des Kondensators deutlich vermindert werden. Beispielsweise kommen Bariumstrontiumtitanat (BST, (Ba,Sr)TiO₃), Bleizirkonattitanat (PZT, Pb(Zr,Ti)O₃) bzw. Lanthan-dotiertes Bleizirkonattitanat oder Strontiumwismuttantalat (SBT, SrBi₂Ta₂O₉) zum Einsatz.

Leider bedingt die Verwendung der neuen Paraelektrika bzw. Ferroelektrika auch die Verwendung neuer Elektrodenmaterialien. Die neuen Paraelektrika bzw. Ferroelektrika werden üblicherweise auf bereits vorhandenen Elektroden (Bodenelektroden) abgeschieden. Die Prozessierung erfolgt unter hohen Temperaturen, bei denen die Materialien, aus denen normalerweise die Kondensatorelektroden bestehen, so z.B. dotiertes Polysilizium, leicht oxidiert werden und ihre elektrisch leitenden Eigenschaften verlieren, was zum Ausfall der Speicherzelle führen würde.

Wegen ihrer guten Oxidationsbeständigkeit und/oder der Ausbildung elektrisch leitfähiger Oxide gelten 4d und 5d Übergangsmetalle, insbesondere Platinmetalle (Ru, Rh, Pd, Os, Ir, Pt) und insbesondere Platin selbst, sowie Rhenium als aussichtsreiche Kandidaten, die dotiertes Silizium/Polysilizium als Elektrodenmaterial ersetzen könnten.

Reicht beim ersten Einsatz der neuen Materialien (z.B. Platin und BST) noch ein einfach strukturierter 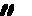 Stack-Kondensator" aus, um die benötigte Kapazität bereitzustellen, so müssen in Folge der weiter fortschreitenden Verkleinerung der Speicherzelle bei weiteren DRAM-Generationen jedoch auch die Kondensatoren, die aus den neuen Materialien bestehen, entsprechend komplexer strukturiert werden, um eine ausreichende Kondensatorfläche zu gewährleisten. Große Oberflächen bei gleichzeitiger geringer lateraler Ausdehnung sind in der Regel nur durch Strukturen zu erzielen, die ein großes Aspektverhältnis (Verhältnis von Höhe zu Breite) aufweisen. Gerade derartige Strukturen können mit den neuen Paraelektrika bzw. Ferroelektrika sowie den neuen Elektrodenmaterialien jedoch nicht oder nur mit großem Aufwand erzeugt werden.

Es ist daher die Aufgabe der vorliegenden Erfindung, ein Verfahren zur Erzeugung von Strukturen mit einem hohen Aspektverhältnis, insbesondere aus den genannten Materialien, sowie eine Struktur einem hohen Aspektverhältnis bereitzustellen.

Diese Aufgabe wird von dem Verfahren zur Erzeugung von Strukturen mit einem hohen Aspektverhältnis gemäß Patentanspruch 1 sowie der Struktur mit einem hohen Aspektverhältnis gemäß Patentanspruch 15 gelöst. Weitere vorteilhafte Ausführungsformen, Ausgestaltungen und Aspekte der vorliegenden Erfindung ergeben sich aus den Unteransprüchen der Beschreibung und den beiliegenden Zeichnungen.

Erfindungsgemäß wird ein Verfahren zur Erzeugung von Strukturen mit einem hohen Aspektverhältnis bereitgestellt, das die folgenden Schritte aufweist:
das Material der zu erzeugenden Struktur wird in Form einer Schicht bereitgestellt,
auf die Schicht wird eine Maske aufgebracht,
die Schicht wird unter Verwendung der Maske trockengeätzt, so daß Redepositionen des Schichtmaterials an den Seitenwänden der Maske gebildet werden,
die Maske wird entfernt, so daß eine Struktur mit einem hohen Aspektverhältnis zurückbleibt.

Durch das erfindungsgemäße Verfahren lassen sich sehr hohe (≥ 1 µm) und sehr dünne (≤ 50 nm) Strukturen in nur sehr wenigen Prozeßschritten und mit nur einer Maskentechnik relativ einfach und schnell erzeugen. Strukturen mit so großen Aspektverhältnissen, insbesondere wenn sie aus einem leitenden Material bestehen, können anders nicht oder nur mit hohem Aufwand erzeugt werden.

Bevorzugt wird zum Trockenätzen der Schicht ein Plasmaätzverfahren verwendet. Weiterhin ist bevorzugt, wenn während der Trockenätzung der Schicht ein Gas oder Gasgemisch, bevorzugt ein Edelgas, vorgesehen ist, das mit dem Material der zu erzeugenden Struktur keine flüchtigen Verbindungen bildet.

Zur Trockenätzung der Schicht können eine Reihe von Vefahren verwendet werden. Bevorzugt werden zur Trockenätzung der Schicht eine reaktive Ionenätzung (RIE, Reactive Ion Etching), eine magnetfeldunterstützte reaktive Ionenätzung (MERIE, Magnetically Enhanced RIE), eine ECR-Ätzung (ECR, Electron Cyclotron Resonance) oder induktiv gekoppelte Plasmaätzverfahren (ICP, TCP) eingesetzt.

Weiterhin ist es vorteilhaft, wenn das Aspektverhältnis der Struktur größer als 2, bevorzugt größer als 10, insbesondere größer als 20, ist.

Bevorzugt ist die Struktur als sich selbst stabilisierende Struktur ausgebildet. Insbesondere ist es bevorzugt, wenn die Struktur als in sich geschlossene Struktur, beispielsweise als geschlossener Ring, ausgebildet ist.

Das erfindungsgemäße Verfahren kann mit einer Vielzahl von Materialien durchgeführt werden. Bevorzugt enthält die Schicht jedoch ein Metall, insbesondere Kupfer, Eisen, Kobalt, Nickel, oder ein 4d oder 5d Übergangsmetall, insbesondere ein Platinmetall. Weiterhin ist es bevorzugt, wenn die Schicht Platin, Gold, Silber, Iridium, Palladium, Ruthenium, Rhenium oder deren Oxide enthält.

Darüber hinaus ist es bevorzugt, wenn auf die Struktur zumindest eine weitere Schicht so aufgebracht wird, daß wiederum eine Struktur mit einem hohem Aspektverhältnis entsteht. Insbesondere ist es bevorzugt, wenn diese weitere Schicht eine Isolationsschicht ist.

Weiterhin ist es bevorzugt, wenn die weitere Schicht ein ferroelektrisches Material, ein dielektrisches Material, insbesondere ein dielektrisches Material hoher relativer Dielektrizitätskonstante, einen Perowskit oder Vorstufen dieser Materialien enthält. Dabei soll unter einer Vorstufe der genannten Materialien ein Material verstanden werden, das durch eine geeignete Wärmebehandlung (z.B. Tempern), gegebenenfalls unter Zuführung von Sauerstoff, in die genannten Materialien umgewandelt werden kann.

So ist es bevorzugt, wenn die weitere Schicht Strontiumwismuttantalat (SBT, SrBi₂Ta₂O₉), Strontiumwismutniobattantalat (SBNT, SrBi₂Ta₂₋ₓNbₓO₉, x=0-2) oder Derivate, Bleizirkonattitanat (PZT, Pb(Zr,Ti)O₃) oder Derivate oder Bariumstrontiumtitanat (BST, BaₓSr₁₋ₓTiO₃, x=0-1), Bleilanthantitanat (PLT, (Pb, La)TiO₃), Bleilanthanzirkonattitanat (PLZT, (Pb, La) (Zr, Ti)O₃) oder Derivate enthält.

Weiterhin ist es bevorzugt, wenn das Material der zu erzeugenden Struktur in Form einer Schicht auf eine leitende Schicht aufgebracht wird. So lassen sich beispielsweise zwei geschlossene Ringe bilden, die über die leitende Schicht elektrisch leitend miteinander verbunden sind. Dies soll auch den Fall umfassen, daß nur eine relativ dicke, leitende Schicht erzeugt wird, wobei das Material des oberen Teils der Schicht zur Erzeugung der Redepositionen und das Material des unteren Teils der Schicht zur leitenden Verbindung der Redepositionen dient.

Die Erfindung wird nachfolgend anhand von Figuren der Zeichnung näher dargestellt. Es zeigen:
Figuren 1 bis 4 eine schematische Darstellung eines erfindungsgemäßen Verfahrens zur Erzeugung von Strukturen mit einem hohen Aspektverhältnis, und
Fig. 5 eine schematische Darstellung einer für das erfindungsgemäße Verfahren verwendeten Ätzkammer in Form eines Parallelplattenreaktors.

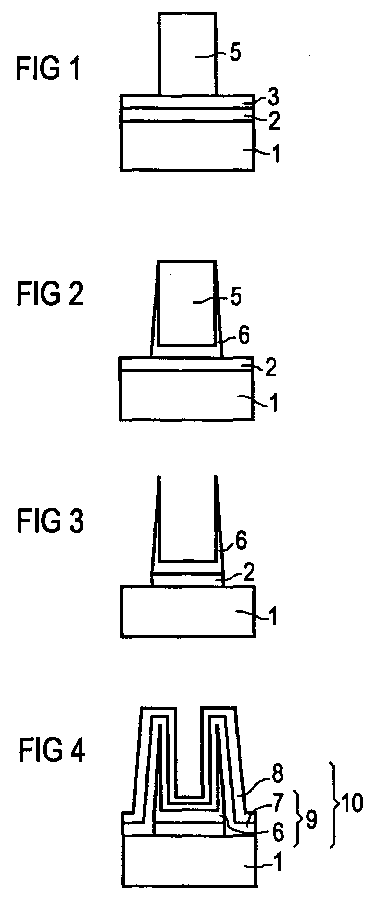

Die Figuren 1 bis 4 zeigen eine schematische Darstellung eines erfindungsgemäßen Verfahrens zur Erzeugung von Strukturen mit einem hohen Aspektverhältnis.

Auf ein Siliziumsubstrat 1 wird eine Barriereschicht 2, beispielsweise TiN, aufgebracht. Auf diese Barriereschicht 2 wird eine Platinschicht 3 durch einen CVD- oder Sputterprozeß abgeschieden. Das Platin der Platinschicht 3 bildet das Material der zu noch erzeugenden Struktur mit einem hohen Aspektverhältnis. Nachfolgend wird noch eine Lackschicht aufgebracht. Diese Lackschicht wird belichtet und entwickelt, so daß die Lackmaske 5 gebildet wird. Anstatt einer Lackmaske 5 könnte auch eine sogenannte 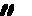 Hardmask", beispielsweise eine 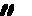 SiO₂-Hardmask" verwendet werden. Die sich daraus ergebende Struktur ist in Fig. 1 gezeigt.

Anschließend wird unter Verwendung der Lackmaske 5 die Platinschicht 3 trockengeätzt. Die Strukturierung der Platinschicht 3 erfolgt durch ein sogenanntes plasmaunterstütztes anisotropes Ätzverfahren. Dabei werden Gasgemische verwendet, die mit dem Platin der Platinschicht keine flüchtigen Verbindungen bilden. Im vorliegenden Fall wurde ein reines Argongas verwendet.

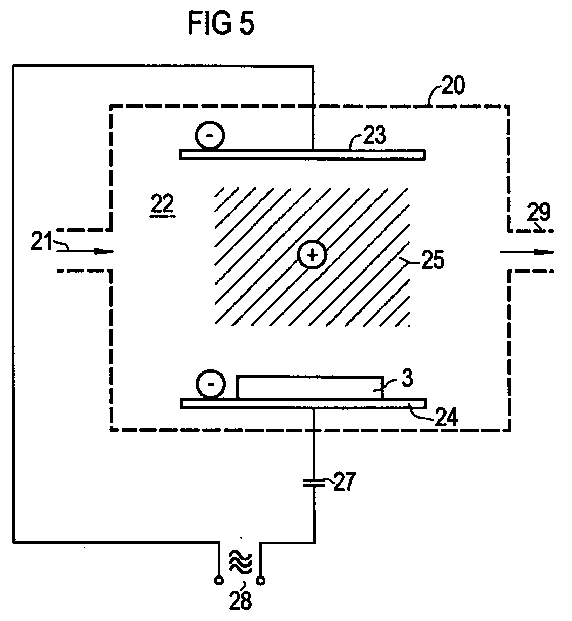

Das Gas wird in einem elektromagnetischen Wechselfeld bei geringen Drücken angeregt. Fig. 5 zeigt die prinzipielle Arbeitsweise des verwendeten Parallelplattenreaktors 20. Das Argongas wird über den Gaseinlass 21 der eigentlichen Reaktorkammer 22 zugeführt und durch den Gasauslass 29 wieder ab-gepumpt. Die untere Platte 24 des Parallelplattenreaktors ist über eine Kapazität 27 mit einer Hochfrequenzguelle 28 verbunden und dient als Substrathalter. Durch das Anlegen eines hochfrequenten elektrischen Wechselfeldes an die obere und die untere Platte 23, 24 des Parallelplattenreaktors wird das Gas in ein Plasma 25 überführt. Da die Beweglichkeit der Elektronen größer als die der Gaskationen ist, laden sich die obere und die untere Platte 23, 24 gegenüber dem Plasma 25 negativ auf. Daher üben beide Platten 23, 24 auf die positiv geladenen Gaskationen eine hohe Anziehungskraft aus, so daß sie einem permanenten Bombardement durch diese Ar⁺-Ionen ausgesetzt sind. Da der Gasdruck zudem niedrig gehalten wird, typischerweise 0.1 - 10 Pa, findet nur eine geringfügige Streuung der Ionen untereinander und an den Neutralteilchen statt, und die Ionen treffen nahezu senkrecht auf die Oberfläche der Platinschicht 3, die über das Substrat 1 (nicht gezeigt) auf der unteren Platte 24 des Parallelplattenreaktors gehalten ist. Dies erlaubt eine gute Abbildung der Maske 5 (nicht gezeigt) auf die darunterliegende, zu ätzende Platinschicht 3.

Die Ätzung der Platinschicht 3 wird nun durch Impuls und kinetische Energie der auftreffenden Ar⁺-Ionen bewirkt. Darüber hinaus finden keine chemische Reaktionen zwischen dem Platin der Platinschicht 3 und den Ar⁺-Ionen statt. Daher kommt es zu Redepositionen 6 (Fig. 2) von abgesputterten Platin an den Seitenwänden der Maske 5. Diese Redepositionen 6 besitzen, in Abhängigkeit von der Höhe der Lackmaske 5, eine große Höhe (≥ 1 µm), sie sind aber gleichzeitig sehr dünn (≤ 50 nm).

Anschließend wird die Barriereschicht 2 durch eine weitere anisotrope Trockenätzung strukturiert und die Lackmaske 5 durch einen Veraschungsschritt entfernt. Wurde anstatt einer Lackmaske eine 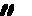 SiO₂-Hardmask" verwendet, so kann diese Maske durch eine weitere Ätzung, einen sogenannten 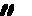 HF-Dip", entfernt werden. Die Redepositionen 6 bleiben dabei erhalten. Auf diese Weise sind Strukturen 6 entstanden, die ein hohes Aspektvehältnis aufweisen (siehe Fig. 3). Dabei ist zu bemerken, daß Figur 3 einen Schnitt durch eine an sich ringförmig geschlossene Redeposition 6 darstellt. Durch die ringförmig geschlossene Form kann sich die Redeposition 6, auch bei einem sehr großen Verhältnis von Höhe zu Breite, selbst mechanisch stabilisieren.

Im nächsten Schritt wird durch einen CVD-Prozeß eine Bariumstrontiumtitanatschicht 7 (BST, (Ba,Sr)TiO₃) auf die Redepositionen 6 möglichst konform aufgebracht. Die Redepositionen 6 und die BST-Schicht 7 bilden somit wiederum eine Struktur 9, die ein hohes Aspektverhältnis aufweist. Nachfolgend wird auf die BST-Schicht 7 eine leitende Schicht 8 aufgebracht. Auch dies kann auf konforme Art und Weise geschehen, so daß eine dritte Struktur 10 entsteht, die ebenfalls ein hohes Aspektverhältnis aufweist. Die daraus resultierende Gesamtstruktur ist in Fig. 4 gezeigt.

Die sich aus dem erfindungsgemäßen Verfahren ergebende Struktur 10 kann nun als sogenannter 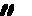 Kronenkondensator" in der Speicherzelle eines DRAM-Speicherbaustein verwendet werden. Durch die Kronenstruktur weist ein solcher Kondensator eine wesentlich größer Fläche als ein einfacher planarer Kondensator auf. Dementsprechend erhöht sich auch die Kapazität des 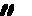 Kronenkondensators".

Reicht die Kapazität eines solchen 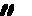 Kronenkondensators" mit einer Wand noch nicht aus, so können auch 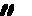 Kronenkondensatoren" mit mehreren Wänden gebildet werden.

Wie gezeigt, lassen sich durch das erfindungsgemäße Verfahren sehr hohe (≥ 1 µm) und sehr dünne (≤ 50 nm) Strukturen in nur sehr wenigen Prozeßschritten und mit nur einer Maskentechnik relativ einfach und schnell erzeugen. Strukturen mit so großen Aspektverhältnissen, insbesondere wenn sie aus einem leitenden Material, insbesondere Platin, bestehen, konnten anders bisher nicht oder nur mit hohem Aufwand erzeugt werden.

## Patentansprüche

1. Verfahren zur Erzeugung von Strukturen mit einem hohen Aspektverhältnis mit den Schritten:
das Material der zu erzeugenden Struktur wird in Form einer Schicht bereitgestellt,
auf die Schicht wird eine Maske aufgebracht,
die Schicht wird unter Verwendung der Maske trockengeätzt, so daß Redepositionen des Schichtmaterials an den Seitenwänden der Maske gebildet werden,
die Maske wird entfernt, so daß eine Struktur mit einem hohen Aspektverhältnis zurückbleibt.

2. Verfahren nach Anspruch 1, dadurch gekennzeichnet, daß zum Trockenätzen der Schicht ein Plasmaätzverfahren verwendet wird.

3. Verfahren nach einem der Ansprüche 1 oder 2, dadurch gekennzeichnet, daß während der Trockenätzung der Schicht ein Gas oder Gasgemisch, bevorzugt ein Edelgas, vorgesehen ist, das mit dem Material der zu erzeugenden Struktur keine flüchtigen Verbindungen bildet.

4. Verfahren nach einem der Ansprüche 1 bis 3, dadurch gekennzeichnet, daß zur Trockenätzung der Schicht eine reaktive Ionenätzung (RIE, Reactive Ion Etching), eine magnetfeldunterstützte reaktive Ionenätzung (MERIE, Magnetically Enhanced RIE), eine ECR-Ätzung (ECR, Electron Cyclotron Resonance) oder induktiv gekoppelte Plasmaätzverfahren (ICP, TCP) eingesetzt werden.

5. Verfahren nach einem der Ansprüche 1 bis 4, dadurch gekennzeichnet, daß das Aspektverhältnis der Struktur größer als 2, bevorzugt größer als 10, ist.

6. Verfahren nach einem der Ansprüche 1 bis 5, dadurch gekennzeichnet, daß die Struktur als sich selbst stabilisierende Struktur ausgebildet ist.

7. Verfahren nach Anspruch 6, dadurch gekennzeichnet, daß die Struktur als in sich geschlossene Struktur ausgebildet ist.

8. Verfahren nach einem der Ansprüche 1 bis 7, dadurch gekennzeichnet, daß die Schicht ein Metall, insbesondere Kupfer, Eisen, Kobalt, Nickel, oder ein 4d oder 5d Übergangsmetall, insbesondere ein Platinmetall, enthält.

9. Verfahren nach Anspruch 8, dadurch gekennzeichnet, daß die Schicht Platin, Gold, Silber, Iridium, Palladium, Ruthenium, Rhenium oder deren Oxide enthält.

10. Verfahren nach einem der Ansprüche 1 bis 9, dadurch gekennzeichnet, daß auf die Struktur zumindest eine weitere Schicht aufgebracht wird, so daß wiederum eine Struktur mit einem hohem Aspektverhältnis entsteht.

11. Verfahren nach Anspruch 10, dadurch gekennzeichnet, daß die weitere Schicht eine Isolationsschicht ist.

12. Verfahren nach Anspruch 11, dadurch gekennzeichnet, daß die weitere Schicht ein ferroelektrisches Material, ein dielektrisches Material, insbesondere ein dielektrisches Material hoher relativer Dielektrizi, einen Perowskit oder Vorstufen dieser Materialien enthält.

13. Verfahren nach Anspruch 12, dadurch gekennzeichnet, daß die weitere Schicht Strontiumwismuttantalat (SBT, SrBi₂Ta₂O₉), Strontiumwismutniobattantalat (SBNT, SrBi₂Ta₂₋ₓNbₓO₉, x=0-2), Bleizirkonattitanat (PZT, Pb(Zr,Ti)O₃) oder Derivate oder Bariumstrontiumtitanat (BST, BaₓSr₁₋ₓTiO₃, x=0-1), Bleilanthantitanat (PLT, (Pb, La)TiO₃), Bleilanthanzirkonattitanat (PLZT, (Pb, La) (Zr, Ti)O₃) oder Derivate enthält.

14. Verfahren nach einem der Ansprüche 11 bis 13, dadurch gekennzeichnet, daß auf die Isolationsschicht eine weitere leitende Schicht aufgebracht wird, so daß wiederum eine Struktur mit einem hohem Aspektverhältnis entsteht.

15. Verfahren nach einem der Ansprüche 1 bis 14, dadurch gekennzeichnet, daß das Material der zu erzeugenden Struktur in Form einer Schicht auf eine leitende Schicht aufgebracht wird.

16. Struktur mit einem hohen Aspektverhältnis, dadurch gekennzeichnet, daß die Struktur nach einem Verfahren gemäß der Patentansprüche 1 bis 15 erhältlich ist.
